# EUROPEAN PATENT SPECIFICATION

(11) **EP 3 206 883 B1**
(45) Date of publication and mention of the grant of the patent: **05.12.2018**
(21) Application number: 15784447.3
(22) Date of filing: 15.10.2015
(51) Int. Cl.: B42D 15/02, B42D 15/04, H05K 1/03

(54) **CAPACITIVE TOUCH DEVICE**
KAPAZITIVER BERÜHRUNGSBILDSCHIRM
DISPOSITIF TACTILE CAPACITIF

(30) Priority: 17.10.2014 GB 201418441
(43) Date of publication of application: 23.08.2017
(73) Proprietor: Novalia Ltd, Cambridge CB5 8RE (GB)
(72) Inventor: STONE, Kate, ICambridge Cambridgeshire CB24 9NP (GB)
(74) Representative: Piotrowicz, Pawel Jan Andrzej
(86) International application number: PCT/GB2015/053057
(87) International publication number: WO 2016/059413

(56) References cited:
- AU-A1- 2014 202 373

## Description

### Field of the Invention

The present invention relates to a capacitive touch device, in particular, a capacitive touch device in the form of a printed article.
Electronic components are increasingly being incorporated into printed items, such as books, posters and greeting cards, to allow these items to become interactive. In particular, capacitive touch sensors are being incorporated into items to allow a user to provide input and the item to respond. Examples of such items are described in GB 2 464 537 A and WO 2004 077286 A.

AU 2014 202 373 describes a method according to the preamble of claim 1 or a touch sensitive sensor system comprising a thin film substrate and a capacitive element of conductive ink deposed on the thin film substrate.

### Summary

According to a first aspect of the present invention there is provided a method of assembling a capacitive touch device. The method comprises providing a flexible sheet having first and second faces and first and second wings divided by a fold line. The flexible sheet supports capacitive touch switches, contact lands and conductive tracks interconnecting the capacitive touch switches and the contact lands on the first face of the flexible sheet. The method comprises providing adhesive on the first face of the flexible sheet so as to bond the first and second wings and to bond a circuit board to the flexible sheet. The method comprises placing a circuit board on the flexible sheet, the circuit board having contact pads which are aligned with the contact lands. The method comprises folding the flexible sheet along the fold line so as to bond the first and second wings with the circuit board interposed between the first and second wings. The flexible sheet further comprises a wing extension extending from the first wing along another fold line and the method further comprises folding the wing extension onto first wing before completing folding the second wing onto the first wing. The wing extension includes an aperture configured to accommodate the circuit board.

The flexible sheet may support capacitive touch switches, contact lands and/or conductive tracks on the first wing and/or second wing.

The capacitive touch switches, contact lands and/or conductive tracks may comprise conductive ink. The conductive ink may be carbon-based conductive ink.

The capacitive touch switches, contact lands and/or conductive tracks may comprise metallic foil.

The flexible sheet may comprise indicia printed on the second face of the flexible sheet. The indicia may include images and/or text. The indicia may comprise one colour of ink. The indicia may comprise more than one colour of ink.

Providing the adhesive on the first face of the flexible sheet may comprise providing the adhesive on the first wing and/or the second wing.

Placing the circuit board on the flexible sheet may comprise placing the circuit board on the first wing.

The flexible sheet may comprise a fibre-based material, such as paper, card or cardboard. The flexible sheet may comprise a plastic material. The flexible sheet may comprise a laminate of one or more layers. The material, e.g. the fibre-based material, may comprise recycled material. This can be environmentally friendly.

Providing the flexible sheet and providing adhesive comprises providing a flexible sheet having an adhesive layer and a peelable backing layer and the method may further comprise removing at least part of backing layer before folding the flexible sheet.

The method may comprise passing the flexible sheet folded along the fold line through a press, such as a roller press.

The method may comprise trimming one or more edges of the device. This may include trimming (and thus removing) the folded edge and so the first and second sheets may not longer be a unitary piece.

The device may include three, four, five or more wings. The wings need not be all the same size.

The fold lines need not all be parallel. For example, one or more fold lines may be perpendicular to another fold line. Thus, a device may be assembled from an 'L'-shaped, a 'T'-shaped, a '+'-shaped or other, more complex layouts. A fold line need not be continuous. For example, a fold line may be split into more than sections by slits or apertures.

### Brief Description of the Drawings

Certain embodiments of the present invention will now be described by way of example, with reference to the accompanying drawings, in which:
Figure 1 is a perspective view of an assembled printed article;
Figure 2 is a perspective view of an unfolded printed sheet before assembly;
Figure 3 shows a backing film being peeled off a printed sheet to reveal an adhesive-covered surface;
Figure 4 is a plan view of capacitive touch elements, contact lands and interconnecting tracks on a printed sheet;
Figure 4a is a more detailed view of capacitive touch elements and conductive tracks shown in Figure 4;
Figure 4b illustrates a threshold level for triggering a response;
Figure 5 shows steps during assembly of the printed article shown in Figure 1;
Figure 6 is a side view illustrating coupling of a contact lands and contact pads through an adhesive layer;
Figure 7 illustrates a step during assembly of the printed article shown in Figure 1;
Figures 8a to 8g illustrate steps during a first process of assembly;
Figure 9 is a flow diagram of a first process of assembly of a printed article;
Figure 10 is a flow diagram of a second process of a printed article; and
Figure 11 is a plan view of an open battery flap.

### Detailed Description of Certain Embodiments

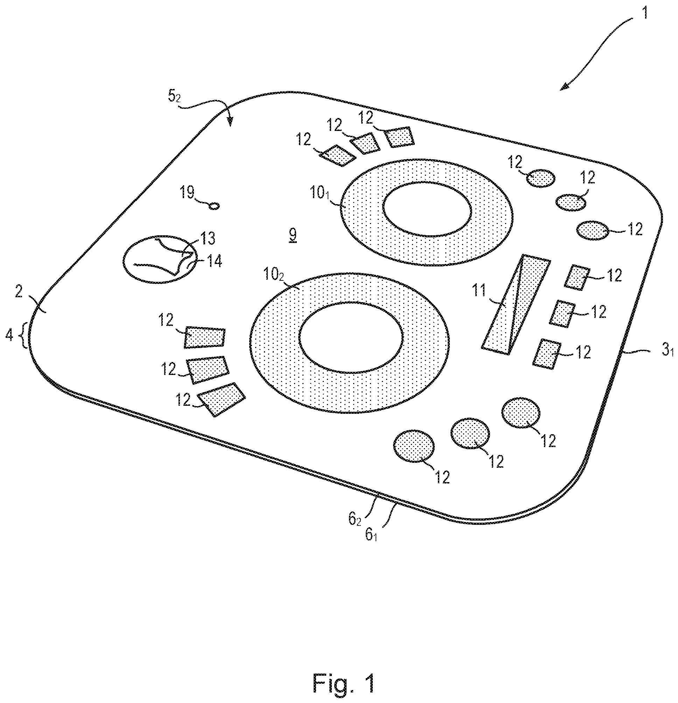

Figure 1 shows a capacitive touch device 1 in the form of a vinyl record sleeve insert.

The capacitive touch device 1 is pairable with a Bluetooth (RTM) enabled mobile device, such as a smart phone, and can be used to provide input signals for controlling the mobile device as described, for example, in WO 2013 117917 A2.

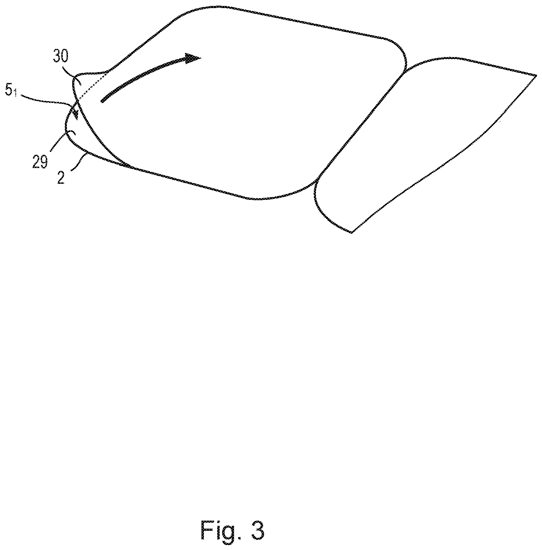

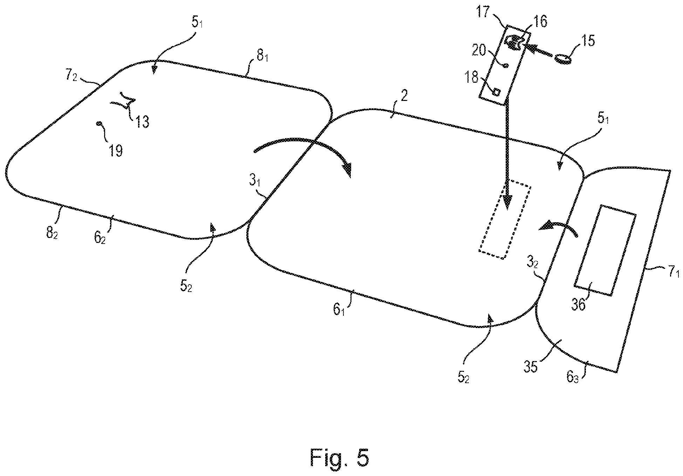

Referring to Figures 1 to 5, the insert 1 comprises a single sheet 2 (best seen in Figure 5) of card which is folded in on itself along first and second fold lines 31, 32 (best seen in Figure 5) to form a laminate structure 4 (best shown in Figure 1). Paper or card can be used having a weight of, for example, about 100 to about 200 g/m². Heavier paper or card or even cardboard can be used, for example, having a weight of up to 350 g/m² or more.

Referring in particular to Figure 5, the sheet 1 has first and second faces 51, 52 and the first fold line 31 separates first and second wings 61, 62. The second fold line 32 separates the first wing 61 and a wing extension 63 (herein also referred to as a "flap"). The sheet 2 has first and second ends 71, 72 and first and second edges 81, 82.

Referring in particular to Figure 1, the second (outward) face 52 of the second wing 62 supports printed indicia 9. In this case, the printed indicia 9 include an image of a DJ mixing desk including images of first and second turntables 101, 102, a crossover slider 11 and other buttons 12.

The second wing 62 includes a tongue-shaped flap 13 held down by a transparent sticker 14. The sticker 14 can be peeled off the area surrounding the flap 13 or entirely removed to allow the flap 13 to be lifted and access a coin cell 15 held in a holder 16 mounted on a circuit board 17 which also supports a microcontroller 18 providing Bluetooth (RTM) wireless connectivity. After the cell 15 has been replaced, the user can reapply or re-stick the sticker 14 or a new sticker (not shown).

The second wing 62 also includes a through-hole 19 which allows ambient light to pass to a photodiode 20 on the circuit board 17. This can be used to pass a signal (not shown) to the microcontroller 18 to switch the microcontroller 18 into a power-saving mode.

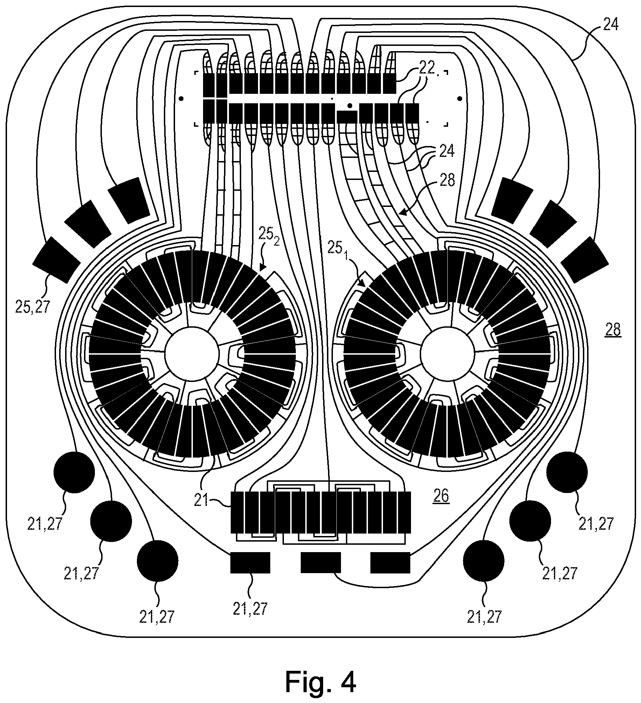

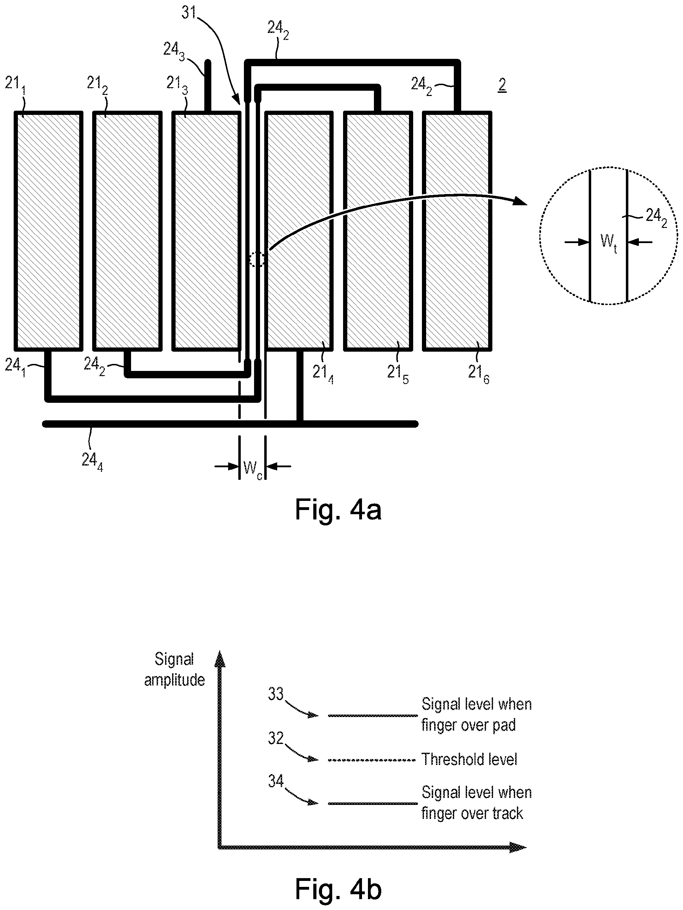

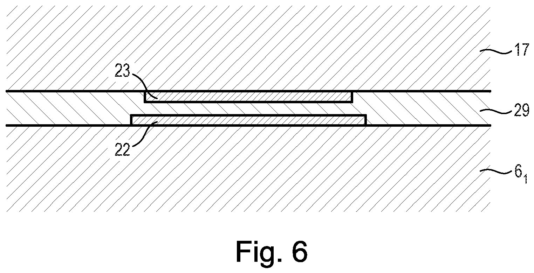

Referring in particular to Figure 4, the first face 51 of the first wing 61 supports a plurality of electrically-conductive pads 21 for providing capacitive touch switches, an array of electrically-conductive pads 22 for providing contact lands for contact pads 23 (Figure 6) on the circuit board 17 and electrically-conductive tracks 24 interconnecting conductive pads 21, 22. The conductive pads 21, 22 and tracks 24 comprise carbon-based conductive ink formed by printing, for example, by lithographic or ink-jet printing process.

Each conductive switch 21 has a surface area which is sufficiently large (e.g. > 0.2 cm²) to provide a capacitive touch pad. Each conductive pad 22 has an area which is sufficiently large to provide electrical capacitive or resistive contact to a contact pad 23 (Figure 6) on the circuit board 17 (Figure 6).

Some of the conductive switches 21 are arranged in an annular array to provide first and second capacitive touch wheels 25₁, 25₂. Other conductive switches 21 are arranged in a linear array to provide a capacitive touch slider 26. Other conductive switches 21 provide simple capacitive touch buttons 27.

The printed indicia 9 and the conductive switches 21 are positioned so that, when the second wing 62 is folded over onto the first wing 61, the images of first and second turntables 10₁, 10₂, crossover slider 11 and other buttons 12 are aligned with corresponding capacitive touch wheels 25₁, 25₂, capacitive touch slider 26 and capacitive touch buttons 27.

The conductive tracks 24 have a width, w, which is sufficiently small (e.g. < 1 mm) so as to reduce capacitive coupling with a finger. As shown in Figure 4, a conductive track 24 may include a section 28 having a ladder-shaped arrangement as described, for example, in WO 2012 101448 A2 which can be used to help to reduce capacitance per unit length of a track 24 without significantly reducing its conductivity.

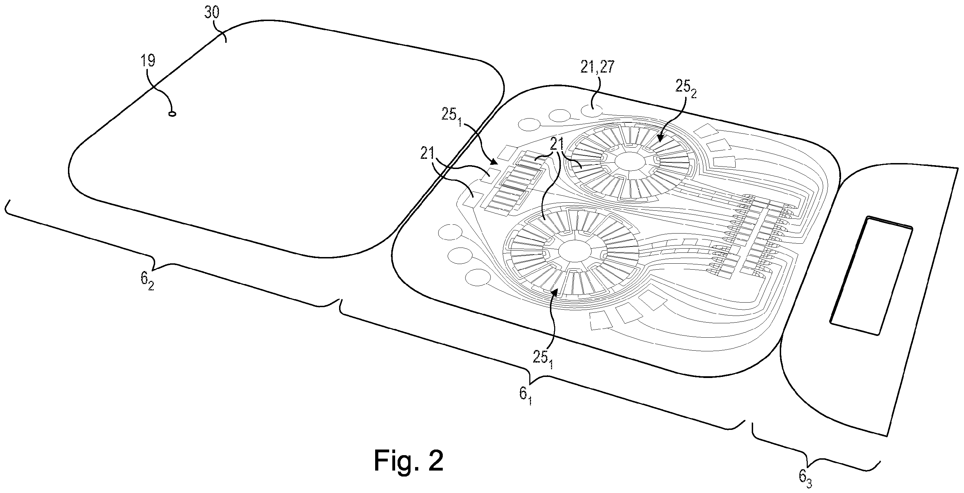

Referring in particular to Figures 2, 3 and 4, the first face 51 of the sheet 2, which includes the conductive pads 21, 22, the conductive tracks 24 and unprinted areas 28, is coated with adhesive 29. In this case, the adhesive 29 is covered by a backing layer 30 which can be peeled away to reveal the adhesive 29.

The adhesive 29 need not applied across all of the first face 51 of the sheet 2. For example, adhesive 29 may be applied in selected areas including, for example, on just the first or second wing 61, 62 and/or around the edges of the wing(s) 61, 62.

An adhesive 29 need not be applied prior to assembly. The adhesive 29 can be applied during assembly. The adhesive 29 can be applied to the required areas by spraying an aerosol-based adhesive, using an adhesive stick, painting or printing liquid-based adhesive or by applying adhesive tape. The adhesive 29 may one which is curable, for example, using heat or UV light.

Referring to Figure 4a, a portion of the capacitive touch slider 26 is shown in more detail.

The touch slider 26 is supported directly on the first face 5₁ of sheet 2 and includes, among others, first, second, third, fourth, fifth and sixth co-planar capacitive touch switches 21₁, 21₂, 21₃, 21₄, 21₅, 21₆ in a row. Conductive tracks 24₁, 24₂, 24₃, 24₄ are also supported directly on the first face 5₁ of the sheet 2, i.e. on the same face as the capacitive touch switches 21₁, 21₂, 21₃, 21₄, 21₅, 21₆.

A first conductive track 24₁ interconnects first and fifth capacitive touch switches 21₁, 21₅. A second conductive track 24₂ interconnects second and sixth capacitive touch switches 21₂, 21₆. Third and fourth conductive tracks 24₃, 24₄ are connected to the third and fourth capacitive touch switches 21₃, 21₄ respectively.

The third and fourth capacitive touch switches 21₃, 21₄ are adjacent and are electrically isolated from each other. The third and fourth capacitive touch switches 21₃, 21₄ are separated by a channel 31 having a width w_{c}.

The first and fifth capacitive touch switches 21₁, 21₅ are electrically isolated from the third and fourth capacitive touch switches 21₃, 21₄. However, the first conductive track 24₁, which interconnects the two switches 21₁, 21₅, runs through the channel 31.

Likewise, second and sixth capacitive touch switches 21₂, 21₆ are electrically isolated from the third and fourth capacitive touch switches 21₃, 21₄ and the second conductive track 24₂, which interconnects the two switches 21₂, 21₆, runs through the channel 31.

In the channel 31, the first and second conductive tracks 24₁, 24₂ have a width wₜ. The channel width w_{c} is at least three times, preferably at least five times, the track width wₜ. The tracks 24₁, 24₂ are about 0.1 mm to 0.5 mm thick in the channel 31.

Thus, as the user passes their finger over the slider 26 over the third and fourth capacitive touch pads 21₃, 21₄, it can activate the third and fourth capacitive touch pad 21₃, 21₄, but not the other pads 21₁, 21₂, 21₅, 21₆ while the finger is over the channel 31.

Referring also to Figure 4b, the microcontroller 18 (Figure 5) provides, among other functions, a capacitive touch controller. The microcontroller 18 is programmed to have a sensing threshold 32 selected such that, in response to a user's finger being directly over a capacitive touch pad 21 it has a signal level 33 which exceeds the threshold level 32 and generates a trigger signal (not shown) indicating that the capacitive touch switch 21 has been "pressed" (i.e. activated), but when a user's finger is over a conductive track 24, the measured signal level 34 falls below the threshold level 32 and so no trigger signal is generated.
A similar arrangement is user for the conductive touch wheels 25₁, 25₂.
Referring to Figure 5, as mentioned earlier, a second fold line 32 separates the first wing 61 and a wing extension 6₃.
The wing extension 6₃ has a frame portion 35 which defines an aperture 36. The aperture 36 is dimensioned to accommodate the circuit board 17 and is positioned so that when the wing extension 6₃ is folded over onto the first wing 61 is creates a shallow cavity over the contact lands 22.
The wing extension 6₃ can be replaced by or augmented by a separate sheet having an aperture. In some cases, the wing extension 6₃ can be omitted.
Referring also to Figure 6, even if a low-conductivity adhesive 29 covers contact lands 22, a contact land 22 and a corresponding contact pad 23 on the circuit board 17 can still be electrically coupled.
First, the contact land 22 and corresponding contact pad 23 can be coupled capacitively as described, for example, in WO 2014 096772 A1.
Secondly, the contact land 22 and corresponding contact pad 23 can be coupled resistively as described, for example, in PCT/GB2014/052832. The adhesive 29 preferably should have a sheet resistance Rs of at least 0.5 MΩ/sq.
However, as mentioned earlier, adhesive 29 may be applied to selective areas of the sheet. If the adhesive 29 is non conductive, then it can be omitted in the region over the contact lands 22. Alternatively, an adhesive 29 which is conductive may be used in which case it may be applied in a dot pattern as described in WO 2013 128198 A2.

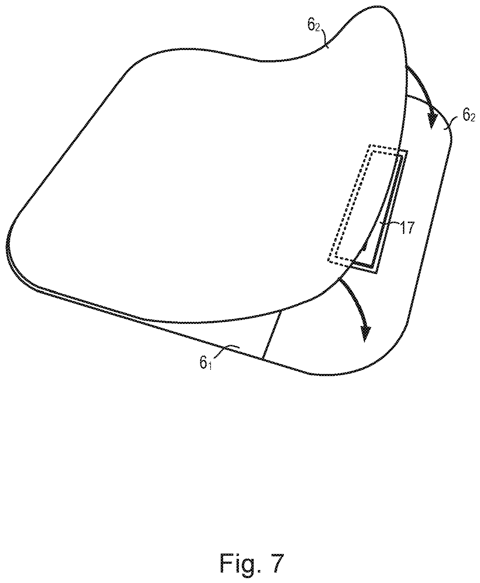

Referring in particular to Figures 2, 5 and 7, the device 1 can be assembled by removing the backing paper 30 (or applying an adhesive 29 on the first face 51 of the sheet 2), folding over the wing extension 6₃ onto the first wing 6₂, placing the circuit board 17 onto the contact lands 22 on the sheet 2 and then folding the second wing 62 onto the first wing 61.

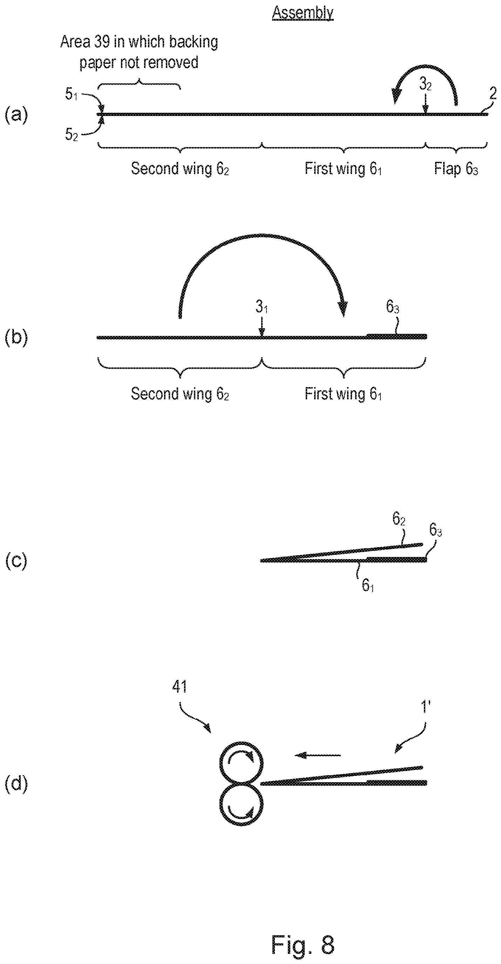

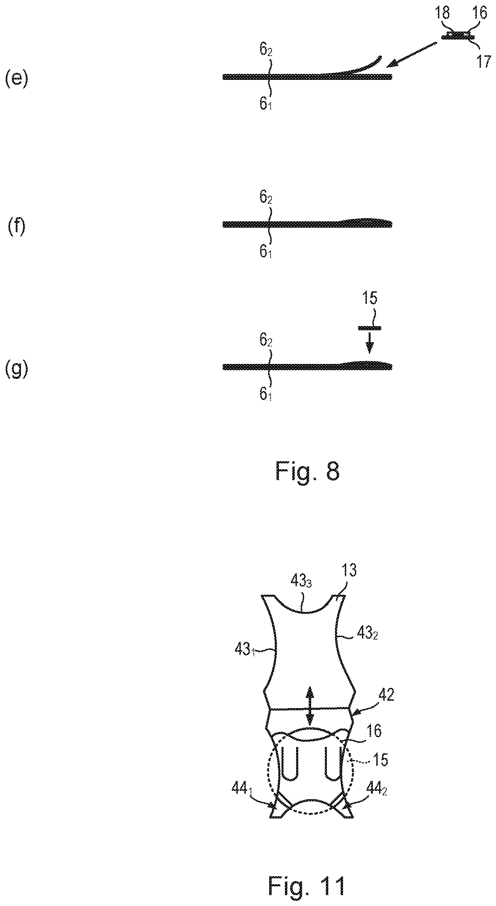

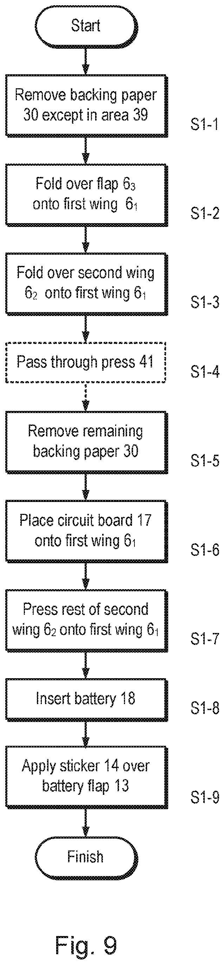

Referring also to Figures 8a to 8g and 9, a specific way of assembling the device 1 is shown.

The backing paper 30 is removed except in area 39 on the second wing 6₂ (step S1-1). The flap 63 is folded and stuck onto the first wing 61 (step S1-2). The second wing 6₂ is then folded over (step S1-3). The partially assembled device 1' can be run through a press 41 (step S1-4). The remaining backing paper 30 can be removed (step S1-5) and the circuit board 17 can be placed onto the first wing (step S1-6). The circuit board 17 can be placed with or without the battery 18 in place. The rest of the second wing 62 is folded over (step S1-7). If not already in place, the battery 18 is inserted (step S1-8). The sticker 14 is applied to the flap 13 (step S1-9).

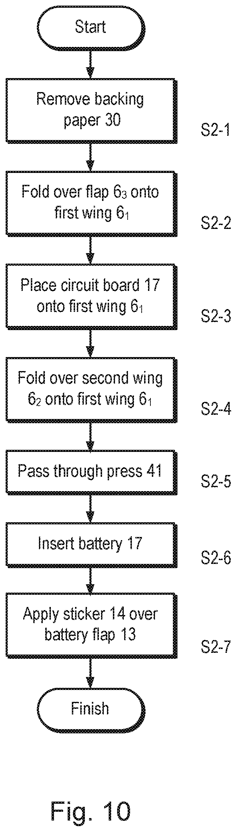

Referring to Figure 10, another ways of assembling the device 1 is shown.

The process is similar to that described earlier with reference to Figure 9. However, the whole device, including circuit board, is passed through the press 41. This may be used particularly when the sheet is at least as thick as the circuit board 17 and any components supported on the board 17 or where an additional spacer insert is used and so the board or components are not subjected to the pressure of the press 41.

Figure 11 shows the coin cell cover flap 13 is open so as to reveal the coin cell holder 16.

Referring to Figure 11, the flap 13 and the corresponding aperture 42 formed in the sheet 2 may have inwardly-concave arcuate edges 43₁, 43₂, 43₃. The arcuate edges 43₁, 43₂, 43₃ in the sheet 2 form spaces 44₁, 44₂ which allow a tool (not shown) to access the coin cell holder 16 and allow it to push out the cell 15 out. Preferably, the flap is formed by cutting slits in the sheet 2 and so is unitary with the rest of the sheet.

It will be appreciated that many modifications may be made to the embodiments hereinbefore described.
The article need not be a vinyl record insert. The article may be a pamphlet, flyer, leaflet or other single sheet article. The printed article may be a promotional item. The printed article may be a map or a cover for a map. The printed article may be postcard or greetings card. The printed article may be a map or a cover for a map. The printed article may be an insert for another item, such as a magazine, book or other product. The printed article may be an insert in or part of product packaging. The product may be media (such as a vinyl record or a CD). The product may be an article of clothing, game or food stuff (such as box of cereal). The insert may be free or bound into another item. The printed article may be a game or playing card. The printed article may be a point-of-sale display.

The device may include three, four, five or more wings. The wings need not be all the same size.

The fold lines need not all be parallel. For example, one or more fold lines may be perpendicular to another fold line. Thus, a device may be assembled from an 'L'-shaped, 'T'-shaped, '+'-shaped or other, more complex layouts.

The printed article may include other forms of output device, such as piezoelectric buzzer or other sound-emitting device, and/or one or more light-emitting diodes or other light-emitting or display device(s).

## Claims

1. A method of assembling a capacitive touch device, the method comprising:
providing a flexible sheet (2) having:
first and second faces (5₁, 5₂); and
first and second wings (6₁, 6₂) divided by a fold line (3₁),
wherein the flexible sheet comprises and supports capacitive touch switches (21), contact lands (22) and conductive tracks (24) interconnecting the capacitive touch switches and the contact lands on the first face of the flexible sheet;
providing adhesive (29) on the first face of the flexible sheet so as to bond the first and second wings and to bond the circuit board to the flexible sheet;
placing a circuit board (17) on the flexible sheet, the circuit board having contact pads (23) which are aligned with the contact lands; and
folding the flexible sheet along the fold line so as to bond the first and second wings with the circuit board interposed between the first and second wings,
wherein the flexible sheet further comprises a wing extension (6₃) extending from the first wing along another fold line (3₂), **characterised in that** the method further comprises:
folding the wing extension onto first wing before completing folding the second wing onto the first wing, and
**in that** the wing extension includes an aperture (36) configured to accommodate the circuit board.

2. A method according to claim 1, wherein providing the flexible sheet and providing adhesive comprises providing a flexible sheet having an adhesive layer and a peelable backing layer, wherein the method further comprises:
removing at least part of backing layer before folding the flexible sheet.

3. A method according to claim 1 or 2, further comprising:
passing the flexible sheet folded along the fold line through a press.

## Patentansprüche

1. Verfahren zum Zusammenbauen einer kapazitiven berührungsempfindlichen Vorrichtung, das Verfahren umfassend:
Bereitstellen eines flexiblen flächigen Elements (2) mit:
einer ersten und einer zweiten Seitenfläche (5₁, 5₂) und
einem ersten und einem zweiten Flügel (6₁, 6₂) die durch eine Faltlinie (3₁) getrennt sind,
wobei das flexible flächige Element kapazitive berührungsempfindliche Schalter (21), Kontaktflächen (22) und Leiterbahnen (24), die die kapazitiven berührungsempfindlichen Schalter und die Kontaktflächen auf der ersten Seitenfläche des flexiblen flächigen Elements miteinander verbinden, umfasst und unterstützt;
Bereitstellen von Klebstoff (29) auf der ersten Seitenfläche des flexiblen flächigen Elements, um den ersten und den zweiten Flügel aneinander zu kleben und die Leiterplatte an das flexible flächige Element zu kleben;
Auflegen einer Leiterplatte (17) auf das flexible flächige Element, wobei die Leiterplatte Kontaktstücke (23) hat, die auf die Kontaktflächen ausgerichtet werden; und
Falten des flexiblen flächigen Elements entlang der Faltlinie, um den ersten und den zweiten Flügel mit zwischen dem ersten und dem zweiten Flügel angeordneter Leiterplatte aneinander zu kleben,
wobei das flexible flächige Element ferner eine Flügelverlängerung (6₃) umfasst, die sich vom ersten Flügel an einer weiteren Faltlinie (3₂) entlang erstreckt, **dadurch gekennzeichnet, dass** das Verfahren ferner umfasst:
Umfalten der Flügelverlängerung auf den ersten Flügel, bevor das Umfalten des zweiten Flügels auf den ersten Flügel abgeschlossen wird, und
dadurch, dass die Flügelverlängerung eine Öffnung (36) aufweist, die zur Aufnahme der Leiterplatte gestaltet ist.

2. Verfahren nach Anspruch 1, wobei das Bereitstellen des flexiblen flächigen Elements und das Bereitstellen von Klebstoff das Bereitstellen eines flexiblen flächigen Elements mit einer Klebstoffschicht und einer abziehbaren Schutzschicht umfasst, wobei das Verfahren ferner umfasst:
Entfernen, wenigstens teilweise, der Schutzschicht vor dem Falten des flexiblen flächigen Elements.

3. Verfahren nach Anspruch 1 oder 2, ferner umfassend:
Führen des entlang der Faltlinie gefalteten flexiblen flächigen Elements durch eine Presse.

## Revendications

1. Procédé d'assemblage d'un dispositif tactile capacitif, le procédé comportant les étapes consistant à :
mettre en oeuvre une feuille souple (2) ayant :
des première et deuxième faces (5₁, 5₂); et
des première et deuxième ailes (6₁, 6₂) divisées par une ligne de pliage (3₁),
dans lequel la feuille souple comporte et supporte des commutateurs tactiles capacitifs (21), des pastilles de contact (22) et des pistes conductrices (24) connectant mutuellement les commutateurs tactiles capacitifs et les pastilles de contact sur la première face de la feuille souple ;
mettre en oeuvre un adhésif (29) sur la première face de la feuille souple de manière à lier les première et deuxième ailes et à lier la carte de circuit imprimé à la feuille souple ;
placer une carte de circuit imprimé (17) sur la feuille souple, la carte de circuit imprimé ayant des plots de contact (23) qui sont alignés sur les pastilles de contact ; et
plier la feuille souple le long de la ligne de pliage de manière à lier les première et deuxième ailes, la carte de circuit imprimé étant intercalée entre les première et deuxième ailes,
dans lequel la feuille souple comporte par ailleurs un prolongement d'aile (6₃) s'étendant depuis la première aile le long d'une autre ligne de pliage (3₂), **caractérisé en ce que** le procédé comporte par ailleurs :
l'étape consistant à plier le prolongement d'aile sur la première aile avant de compléter le pliage de la deuxième aile sur la première aile, et
**en ce que** le prolongement d'aile comprend une ouverture (36) configurée pour recevoir la carte de circuit imprimé.

2. Procédé selon la revendication 1, dans lequel l'étape consistant à mettre en oeuvre la feuille souple et à mettre en oeuvre un adhésif comporte l'étape consistant à mettre en oeuvre une feuille souple ayant une couche adhésive et une couche dorsale pelable, dans lequel le procédé comporte par ailleurs :
l'étape consistant à retirer au moins une partie de la couche dorsale avant de plier la feuille souple.

3. Procédé selon la revendication 1 ou la revendication 2, comportant par ailleurs :
l'étape consistant à faire passer la feuille souple pliée le long de la ligne de pliage au travers d'une presse.
